Europäisches Patentamt

European Patent Office

Office européen des brevets

(11) Veröffentlichungsnummer: **0 536 751 A2**

# EUROPÄISCHE PATENTANMELDUNG

(21) Anmeldenummer: **92117205.2**

(51) Int. Cl.5: **G11C 17/12**

(22) Anmeldetag: **08.10.92**

(30) Priorität: **09.10.91 DE 4133490**

(43) Veröffentlichungstag der Anmeldung:
**14.04.93 Patentblatt 93/15**

(84) Benannte Vertragsstaaten:
**CH DE FR GB IT LI SE**

(71) Anmelder: **TEXAS INSTRUMENTS DEUTSCHLAND GMBH**
**Haggertystrasse 1**
**W-8050 Freising(DE)**

(72) Erfinder: **Prexl, Franz**
**Erdinger Strasse 17**
**W-8059 Niederding(de)**

(74) Vertreter: **Schwepfinger, Karl-Heinz, Dipl.-Ing.**
**Prinz & Partner, Manzingerweg 7**
**W-8000 München 60 (DE)**

(54) **Integrierte Halbleiterspeichervorrichtung.**

(57) Eine integrierte Halbleiterspeichervorrichtung (10) enthält zeilen- und spaltenweise angeordnete Speicherzellen, die jeweils einen MOS-Feldeffekttransistor (T) mit einer nicht angeschlossenen Gate-Elektrode (14) enthalten. Die Drain-Elektroden aller MOS-Feldeffekttransistoren (T) in einer Spalte sind miteinander verbunden und an die zugehörige Spaltenleitung (20) angeschlossen. Die Gate-Elektroden aller MOS-Feldeffekttransistoren (T) in einer Zeile sind ebenfalls miteinander verbunden und an eine zugehörige Zeilenleitung (16) angeschlossen. Die Source-Elektroden aller MOS-Feldeffekttransistoren (T) sind miteinander verbunden und an einen eigenen Steueranschluß (26) angeschlossen.

Rank Xerox (UK) Business Services
(3.10/3.5x/3.0.1)

Die Erfindung bezieht sich auf eine integrierte Halbleiterspeichervorrichtung mit zeilen- und spaltenweise angeordneten Speicherzellen, die jeweils einen MOS-Feldeffekttransistor mit einer zusätzlichen, nicht angeschlossenen Gate-Elektrode enthalten, wobei die Drain-Elektroden aller MOS-Feldeffekttransistoren in einer Spalte miteinander verbunden und an die zugehörige Spaltenleitung angeschlossen sind, während die Gate-Elektroden aller MOS-Feldeffekttransistoren in einer Zeile miteinander verbunden und an eine zugehörige Zeilenleitung angeschlossen sind.

Halbleiterspeichervorrichtungen, deren Zellen MOS-Feldeffekttransistoren mit einer zusätzlichen, nicht angeschlossener Gate-Elektrode enthalten, gehören zu den nicht flüchtigen Speichervorrichtungen, d.h. zu den Speichervorrichtungen, bei denen die gespeicherte Information auch dann gespeichert bleibt, wenn keine Versorgungsspannung am Speicher anliegt. Bekannte Halbleiterspeichervorrichtungen dieser Art benötigen für ihren Betrieb Spannungen beider Polaritäten, nämlich beispielsweise eine positive Lesespannung, eine positive Löschspannung und eine negative Programmierspannung. Das Erfordernis der negativen Spannung hat jedoch beträchtliche Nachteile. Wegen der negativen Spannung dürfen an der Zeilenleitung der Matrix keine N-Kanal-Transistoren angeschlossen sein. Bei einem Lesevorgang muß neben der eigentlichen Lesespannung eine weitere negative Spannung angewendet werden, damit die in der Speichervorrichtung vorhandenen P-Kanaltransistoren nach Masse leitend gemacht werden können. Das Ein- und Ausschalten der negativen Programmierspannung kann nur mit einer noch negativeren Spannung erfolgen, die zusätzlich intern erzeugt oder von außen zur Verfügung gestellt werden muß. Die in der Halbleiterspeichervorrichtung verwendeten P-Kanaltransistoren liegen im Halbleitersubstrat in eigenen isolierenden Wannen, die immer auf der gerade vorhandenen positivsten Spannung gehalten werden müssen.

Da bei allen bekannten Halbleiterspeichervorrichtungen dieser Art alle Source-Anschlüsse der Speichertransistoren mit Masse verbunden sind, würde der Verzicht auf eine negative Programmierspannung dazu führen, daß alle nicht adressierten, aber bereits zu einem früheren Zeitpunkt programmierten Transistoren in der gerade adressierten Spalte leitend sind und somit die während des Programmiervorgangs an die gerade adressierte Spalte angelegte Programmierspannung belasten. Dies ist nicht erwünscht, da die Programmierspannung in der Regel nicht niederohmig an der Halbleiterspeichervorrichtung zur Verfügung steht. Dies trifft besonders zu, wenn die Programmierspannung intern mit Hilfe einer Ladepumpe erzeugt wird.

Nur ein weiterer Transistor pro Speicherzelle in Reihe geschaltet kann den Stromfluß durch die nicht adressierten, aber bereits programmierten Speicherzellen verhindern. Das würde allerdings auch zu einer Verdoppelung des Flächenbedarfs führen.

Der Erfindung liegt die Aufgabe zugrunde, eine integrierte Halbleiterspeichervorrichtung der eingangs angegebenen Art zu schaffen, bei der alle Funktionen mit Spannungen einer Polarität erzielt werden können.

Erfindungsgemäß wird diese Aufgabe dadurch gelöst, daß die Source-Elektroden aller MOS-Feldeffekttransistoren miteinander verbunden und an einen eigenen Steueranschluß der Matrix angeschlossen sind.

Durch die getrennte Zugänglichkeit der Source-Elektroden aller MOS-Feldeffekttransistoren können durch Anlegen entsprechender unterschiedlicher Spannungen einer Polarität (beispielsweise nur positiv) alle erforderlichen Betriebsfunktionen wie Programmieren, Löschen und Lesen durchgeführt werden.

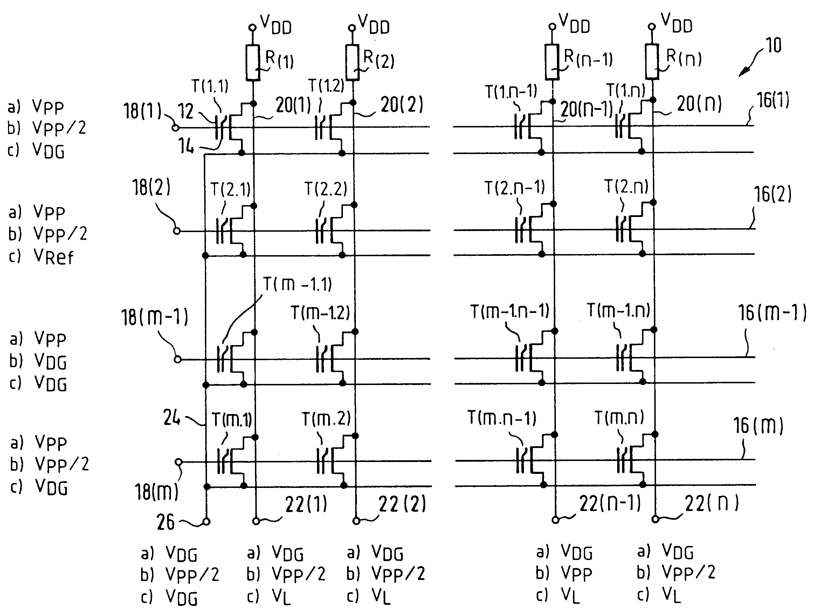

Die Erfindung wird nun anhand der Zeichnung beispielshalber erläutert, deren einzige Figur eine schematische Darstellung der Halbleiterspeichervorrichtung mit Speicherzellen aus jeweils einem MOS-Feldeffekttransistor zeigt.

Die in der Zeichnung dargestellte Halbleiterspeichervorrichtung 10 enthält zeilen- und spaltenweise angeordnete MOS-Feldeffekttransistoren T, wobei zur Verdeutlichung bei jedem dieser Transistoren in Klammer jeweils die Zeilennummer und die Spaltennummer angegeben sind. Die Feldeffekttransistoren T enthalten neben der seiner Steuerung dienenden Gate-Elektrode 12 eine nicht angeschlossene Gate-Elektrode 14, die in der englischsprachigen Fachliteratur als "floating gate" bezeichnet wird. Diese nicht angeschlossenen Gate-Elektroden können in bekannter Weise durch Anlegen entsprechender Potentiale an den Feldeffekttransistor durch Zufuhr negativer Elektronen aufgeladen werden. Diese Ladung bleibt gespeichert, auch wenn keine Betriebsspannung am Feldeffekttransistor T anliegt. In jedem der Feldeffekttransistoren T kann ein Datenbit gespeichert werden, wobei entweder der geladenen Zustand oder der nicht geladenen Zustand der nicht angeschlossenen Gate-Elektrode 14 dem Datenwert "0" oder dem Datenwert "1" zugeordnet ist.

Wie in der Zeichnung zu erkennen ist, sind die Gate-Elektroden 12 aller Feldeffekttransistoren T einer Zeile an eine Zeilenleitung 16(1)...16(m) angeschlossen. Über eine Klemme 18(1)... 18(m) kann an die jeweilige Zeilenleitung 16(1)...16(m) eine Spannung an die Gate-Elektroden 12 der Transistoren T angelegt werden.

Die Drain-Elektroden der Transistoren T einer Spalte sind jeweils an eine Spaltenleitung 20(1)-...20(n) angeschlossen. Ein Ende der Spaltenleitungen 20(1)...20(n) ist während des Lesevorgangs über einen Widerstand R(1)...R(n) an die Versorgungsspannung $V_{DD}$ gelegt. Das andere Ende der Spaltenleitungen 20(1)...20(n) ist mit entsprechenden Anschlußklemmen 22(1)... 22(n) verbunden.

Die Source-Elektroden aller Transistoren T in der Halbleiterspeichervorrichtung 10 sind an eine Leitung 24 angeschlossen, an die über einen Steueranschluß 26 eine Spannung angelegt werden kann.

Für die in der Zeichnung dargestellte Halbleiterspeichervorrichtung 10 sind drei Betriebsarten zu unterscheiden. In einem Löschbetrieb können die nicht angeschlossenen Gate-Elektroden 14 aller Transistoren T mit Elektronen negativ aufgeladen werden. Dadurch wird ein definierter Anfangszustand für die Halbleiterspeichervorrichtung 10 erreicht, der definitionsgemäß so festgelegt werden kann, daß in allen von den Transistoren T gebildeten Speicherzellen ein Datenbit mit dem Wert "0" gespeichert ist.

Ferner gibt es einen Programmierbetrieb, der auch als Schreibbetrieb bezeichnet werden kann, bei dem die nicht angeschlossene Gate-Elektrode 14 des ausgewählten Transistors T entladen wird, so daß das in der entsprechenden Speicherzelle gespeicherte Datenbit den Wert "1" repräsentiert.

Die dritte Betriebsart ist das Lesen des Inhalts einer ausgewählten Speicherzelle, also die Feststellung, ob bei dem die ausgewählte Speicherzelle bildenden Transistor T die nicht angeschlossene Gate-Elektrode geladen oder entladen ist.

Diese drei Betriebsarten können durch Anlegen unterschiedlicher Spannungen an die Anschlußklemmen 18, 22 und 26 erreicht werden. In der Zeichnung sind an jeder dieser Anschlußklemmen bei a), b) und c) jeweils die Spannungen angegeben, die für den Löschbetrieb (a), den Programmierbetrieb (b) und den Lesebetrieb (c) angelegt werden müssen.

Für die nachfolgende Beschreibung der einzelnen Betriebsarten sei angenommen, daß die Spannungen bezogen auf das Massepotential $V_{DG}$ folgende Werte haben:

$V_{Ref}$ = 2 V
$V_{DD}$ = 5 V
$V_{PP}$ = 16 V
$V_{PP}/2$ = 8 V

Wie oben erwähnt wurde, werden beim Löschen aller Speicherzellen der Matrix die nicht angeschlossenen Gate-Elektroden 14 aller Transistoren T durch Elektronen negativ aufgeladen. Dies wird erreicht, indem an alle Source-Elektroden und an alle Drain-Elektroden der Transistoren T das Massepotential $V_{DG}$ angelegt wird. Gleichzeitig wird an die Gate-Elektroden 12 aller Transistoren T die Spannung $V_{PP}$, d.h. die höchste verfügbare positive Spannung angelegt.

Bei diesen Spannungsverhältnissen gelagen Elektronen auf die nicht angeschlossenen Gate-Elektroden 14, so daß die gewünschte Aufladung auf ein negatives Potential erreicht wird. Die Elektronen gelangen dabei durch den sogenannten Tunnel-Effekt zu der jeweiligen nicht angeschlossenen Gate-Elektrode 14, der nur bei Vorhandensein bestimmter Spannungsverhältnisse eintritt. Wenn keine Spannungen mehr an den Feldeffekttransistoren T anliegen, bleibt die Ladung auf den nicht angeschlossenen Gate-Elektroden 14 bestehen und verringert sich nur durch Leckströme, die aber extrem niedrig sind.

Wenn in den Halbleiterspeicher 10 Daten geschrieben werden sollen, wird ein Programmierschritt durchgeführt, bei dem in ausgewählter Weise einzelne Speicherzellen der Halbleiterspeichervorrichtung angesprochen und die im Feldeffekttransistor T der angesprochenen Speicherzelle enthaltene Ladung geändert werden kann. Beispielsweise sei angenommen, daß die Ladung der nicht angeschlossenen Gate-Elektrode 14 des Feldeffekttransistors T(m-1.n-1) abgeleitet werden soll, diese Gate-Elektrode also entladen werden soll. Zu diesem Zweck werden an die Halbleiterspeichervorrichtung 10 die Spannungen angelegt, die in der Zeichnung jeweils bei b) angegeben sind.

Vor dem Programmierschritt haben alle Speicherzellen den gleichen Zustand, nämlich negativ geladene nicht angeschlossene Gate-Elektroden 14. Diese negative Ladung kann dabei entweder den Binärwert "0" oder "1" repräsentieren. Zur Änderung des Ladungszustands der nicht angeschlossenen Gate-Elektrode 14 des Feldeffekttransistors T(m-1.n-1) wird wie folgt vorgegangen:

1. An die Source-Elektroden aller Feldeffekttransistoren T wird über den Steueranschluß 26 die Spannung $V_{PP}/2$ angelegt.

2. An die Drain-Elektroden der Feldeffekttransistoren T in der Spalte, in der sich der anzusprechende Feldeffekttransistor T(M-1.N-1) befindet, wird die höchste vorhandene positive Spannung $V_{PP}$ angelegt; das Anlegen erfolgt somit an die Anschlußklemme 22 (n-1).

3. An die Gate-Elektroden aller Feldeffekttransistoren in der Zeile, in der sich der anzusprechende Feldeffekttransistor T(m-1.n-1) liegt, wird die Spannung $V_{DG}$, also Masse, angelegt.

An allen verbleibenden Drain- und Gateelektroden wird $V_{PP}/2$ angeschlossen. Somit ist sichergestellt, daß kein Transistor stromführend ist und auch die Spannungsdifferenz $V_{PP}-V_{PP}/2$ nicht zu einer Programmierung führt.

Auf diese Weise liegt nur an der Gate-Elektrode 12 des Feldeffekttransistors T(m-1.n-1) Masse ($V_{DG}$), an seiner Drain-Elektrode liegt die Spannung $V_{PP}$ und an seiner Source-Elektrode liegt die Spannung $V_{PP}/2$. Die Spannungsdifferenz zwischen der Gate-Elektrode und der Drain-Elektrode reicht aus, um das Abfließen der auf der nicht angeschlossenen Gate-Elektrode 14 vorhandenen Elektronen zu bewirken, so daß diese Gate-Elektrode 14 in der gewünschten Weise entladen wird. Wenn angenommen wird, daß eine Speicherzelle, deren Feldeffekttransistor eine negativ aufgeladene nicht angeschlossene Gate-Elektrode 14 aufweist, den gespeicherten Binärwert "0" repräsentiert, dann ist nun im Feldeffekttransistor T(m-1.n-1) der Binärwert "1" gespeichert.

Zum Lesen des Inhalts der Speicherzellen der Halbleiterspeichervorrichtung 10 werden diejenigen Spannungen angelegt, die in der Zeichnung bei c) angegegeben sind. Beispielsweise sei angenommen, daß der Inhalt der den Feldeffekttransistor T(2.2) enthaltenden Speicherzelle gelesen werden soll. Dazu wird folgendes ausgeführt:

1. An die Source-Elektroden aller Feldeffekttransistoren wird über den Steueranschluß 26 die Spannung $V_{DG}$, also Masse, angelegt.

2. An die Gate-Elektroden 12 aller Feldeffekttransistoren der Zeile, in der sich der für das Lesen ausgewählte Feldeffekttransistor T(2.2) befindet, wird die Lesespannung $V_{Ref}$ angelegt. Dieses Anlegen geschieht an die Anschlußklemme 18(2) der Spaltenleitung 16(2).

Unter diesen Bedingungen kann an dem an die Spaltenleitung 20 (2) angeschlossene Widerstand R(2) ein Spannungsabfall über die Anschlußklemme 22(2) abgegriffen werden, der eine Aussage darüber zuläßt, ob die nicht angeschlossene Gate-Elektrode 14 des Feldeffekttransistors T(2.2) geladen oder nicht geladen ist. Wenn die nicht angeschlossene Gate-Elektrode 14 dieses Feldeffekttransistors entladen ist, wird der Transistor durch die relativ niedrige Spannung $V_{Ref}$ in den leitenden Zustand versetzt, so daß ein Strom durch den Widerstand R(2) fließen wird. Dieser Strom ergibt den als Lesespannung $V_L$ abgreifbaren Spannungsabfall. Ist dagegen die nicht angeschlossene Gate-Elektrode 14 dieses Feldeffekttransistors T(2.2) negativ geladen, dann bleibt dieser Feldeffekttransistor auch beim Anlegen der Spannung $V_{Ref}$ an seine Gate-Elektrode 12 gesperrt, so daß kein Strom durch den Widerstand R(2) fließt und demgemäß auch keine Lesespannung $V_L$ an der Anschlußklemme 22(2) abgegriffen werden kann.

Somit ist gezeigt worden, daß unter Anwendung ausschließlich positiver Spannungen alle für den Betrieb der Halbleiterspeichervorrichtung 10 notwendigen Funktionen, nämlich das Löschen, das Programmieren und das Lesen, durchgeführt werden können. Die Erzeugung negativer Spannungen erübrigt sich daher, was die Herstellung der Halbleiterspeichervorrichtung 10 in Form einer integrierten Schaltung beträchtlich erleichtert.

**Patentansprüche**

1. Integrierte Halbleiterspeichervorrichtung mit zeilen- und spaltenweise angeordneten Speicherzellen, die jeweils einen MOS-Feldeffekttransistor mit einer zusätzlichen, nicht angeschlossenen Gate-Elektrode enthalten, wobei die Drain-Elektroden aller MOS-Feldeffekttransistoren in einer Spalte miteinander verbunden und an die zugehörige Spaltenleitung angeschlossen sind, während die Gate-Elektroden aller MOS-Feldeffekttransistoren in einer Zeile miteinander verbunden und an eine zugehörige Zeilenleitung angeschlossen sind, **dadurch gekennzeichnet**, daß die Source-Elektroden aller MOS-Feldeffekttransistoren (T) miteinander verbunden und an einen eigenen Steueranschluß (26) angeschlossen sind.